# EUROPÄISCHE PATENTSCHRIFT

(11) **EP 1 192 473 B1**
(45) Veröffentlichungstag und Bekanntmachung des Hinweises auf die Patenterteilung: **03.08.2005**
(21) Anmeldenummer: 00945760.7
(22) Anmeldetag: 16.06.2000
(51) Int. Cl.: G01R 15/20

(54) **STROMSENSOR**
CURRENT SENSOR
DETECTEUR DE COURANT

(30) Priorität: 22.06.1999 DE 19928399
(43) Veröffentlichungstag der Anmeldung: 03.04.2002
(73) Patentinhaber: HONEYWELL AG, 63067 Offenbach am Main (DE)
(72) Erfinder: KINZEL, Helmut, D-69469 Weinheim (DE)
(74) Vertreter: Pellmann, Hans-Bernd, Dipl.-Ing.
(86) Internationale Anmeldenummer: PCT/EP2000/005549
(87) Internationale Veröffentlichungsnummer: WO 2000/079291

(56) Entgegenhaltungen:
- EP-A- 0 155 391
- DE-A- 19 549 181
- DE-A- 19 741 417
- US-A- 4 559 495
- US-A- 4 894 610
- US-A- 5 642 041

## Beschreibung

Die Erfindung betrifft einen Stromsensor gemäß dem Oberbegriff des Anspruchs 1.

Stromsensor nach der Technik bestehen aus einem Magnetfeldsensor, einem Eisenkern und einem Verstärker. Der Eisenkern umgibt eine den zu messenden Strom führende Stromleitung aus vorzugsweise Kupfer, wodurch im Eisenkern abhängig von der Stärke des Stroms ein Magnetfeld erzeugt wird. Innerhalb eines Spalts des Eisenkerns ist der Magnetfeldsensor angeordnet. Die Feldlinien des im Eisenkern vom zu messenden Storm induzierten Magnetfelds bewegen sich so durch den Magnetfeldsensor, der ein dem zu messenden Strom proportionales Ausgangssignal erzeugt, welches vom Verstärker verstärkt wird. Diesbezügliche Details können dem Aufsatz "Analoge Stromsensoren zum Messen aller Stromformen, Honeywell Outline, Jahrgang 9 (1995), Heft 2, S. 10-11" entnommen werden. Weitere Stromsensoren nach dem Stand der Technik sind aus DE 37 02 344 A1, DE 42 11 548 A1, EP 0 578 948 A1, US 5,041,780 und DE 296 06 606 U1 bekannt.

Die EP 0 155 391 A1 betrifft einen Magnetfeldsensor, bei dem in einem zylindrischen oder teilzylindrischen Gehäuse vier magnetfeldempfindliche Widerstände derart angeordnet sind, dass die empfindliche Achse des Magnetfeldsensors die Längsachse des Zylinders oder eine dazu parallele Achse ist. Die vier magnetfeldempfindlichen Widerstände sind als Withstonesche Brücke miteinander verbunden. Der Magnetfeldsensor ist von einem elektrischen Stromleiter in Gestalt einer omegaförmigen Schelle umschlungen. Mittels des Magnetfeldsensors kann ein durch die Schelle fließender Strom gemessen werden. Die Schelle dient zugleich zur Befestigung des Magnetfeldsensors auf einem Träger.

Ein weiteres Erfassungselement dieser Art ist der US 4,559,495 entnehmbar. Der dort gezeigte Aufnehmer hat keinen Magnetkern und erfasst den Strom kontaktlos.

Der bei Stromsensoren nach dem Stand der Technik ansonsten übliche Eisenkern übernimmt in erster Linie zwei Aufgaben, nämlich einerseits die Leitung des vom zu messenden Strom induzierten Magnetfelds durch den Magnetfeldsensor und andererseits die Abschirmung des Magnetfeldsensors gegenüber Fremdfeldern. Durch die Verwendung der Eisenkerne sind die Stromsensoren nach dem Stand der Technik jedoch zu teuer.

Hiervon ausgehend liegt der vorliegenden Erfindung das Problem zugrunde, einen neuartigen Stromsensor zu schaffen, der klein sowie preiswert und dennoch fremdfeldsicher ist.

Zur Lösung dieses Problems ist der eingangs genannte Stromsensor durch die Merkmale des Anspruchs 1 gekennzeichnet.

Der erfindungsgemäße Stromsensor kommt ohne Eisenkern aus. Der aus leitendem, ferritischem Material hergestellte Stromleiter, der den Magnetfeldsensor zumindest bereichsweise umschließt, übernimmt demnach die Funktionen des sonst üblichen Eisenkerns.

Bevorzugte Weiterbildungen der Erfindung ergeben sich aus den Unteransprüchen und der Beschreibung. Nachfolgend werden Ausführungsbeispiele der Erfindung anhand der Zeichnungen näher erläutert. In der Zeichnung zeigt:
- Fig. 1: eine stark vereinfachte Prinzipskizze eines erfindungsgemäßen Stromsensors in Seitenansicht,
- Fig. 2: eine stark vereinfachte Prinzipskizze des erfindungsgemäßen Stromsensors gemäß Fig. 1 in Draufsicht,
- Fig. 3: eine stark vereinfachte Prinzipskizze eines weiteren erfindungsgemäßen Stromsensors in perspektivischer Ansicht,
- Fig. 4: eine Verdeutlichung des Feldlinienverlaufs durch die erfindungsgemäßen Stromsensoren, und
- Fig. 5: den Stromsensor gemäß Fig. 1 in Verbindung mit einer Leiterplatte.

Die in der Zeichnung dargestellten Stromsensoren dienen der Messung des von einem Stromleiter geführten Stroms.

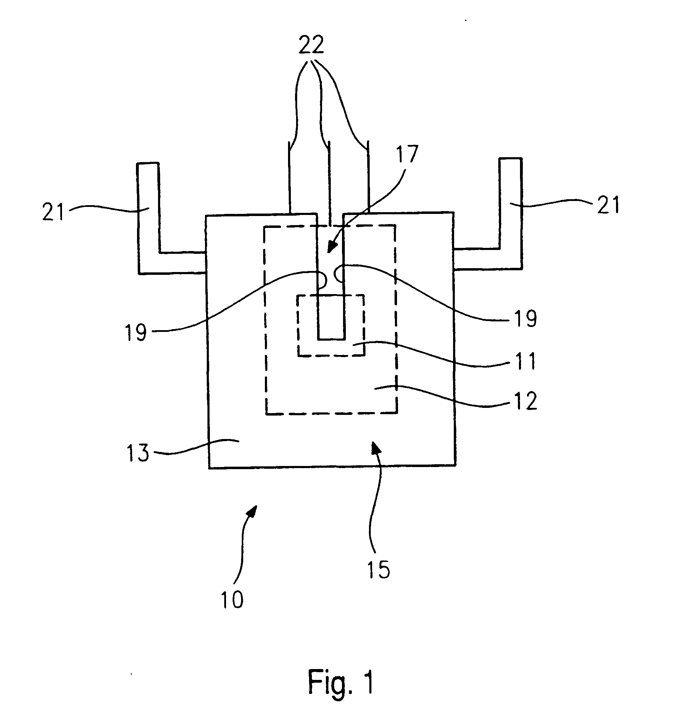

Fig. 1 zeigt einen erfindungsgemäßen Stromsensor 10 in einer stark schematisierten Darstellung. Der Stromsensor 10 verfügt über einen Magnetfeldsensor 11 - im gezeigten Ausführungsbeispiel über einen Hall-Sensor - und über einen dem Magnetfeldsensor 11 zugeordneten Verstärker (nicht gezeigt). Der Magnetfeldsensor 11 und der Verstärker sind auf einer Trägerplatte 12 montiert.

Der Magnetfeldsensor 11 wird erfindungsgemäß vom Stromleiter 13, der den zu messenden Strom führt, zumindest bereichsweise umschlossen. Hierzu verfügt der Stromleiter 13 über eine bandförmige Gestalt. Der Stromleiter 13 umschließt demnach den Magnetfeldsensor 11 röhrenförmig. Es ist auch denkbar, daß diese röhrenförmige Anordnung des Stromleiters 13 an Oberseite und/oder Unterseite geschlossen ist. Dann würde eine hülsenförmige oder gehäuseförmige Umschließung des Magnetfeldsensors 11 durch den Stromleiter 13 vorliegen. Darüber hinaus ist der Stromleiter 13 aus leitendem, ferritischem Material hergestellt. Dieser aus leitendem, ferritischem Material hergestellte und die bandförmige Gestalt aufweisende Stromleiter 13 ist um den Magnetfeldsensor 11 herum angeordnet. Der so ausgebildete Stromleiter 13 sorgt demnach für eine Abschirmung des Magnetfeldsensors 11 gegenüber Fremdfeldem. Des weiteren wird auf diese Weise das vom zu messenden Strom erzeugte Magnetfeld durch den Magnetfeldsensor 11 geführt. Auf den bei Stromsensoren nach dem Stand der Technik nötigen Eisenkern kann also verzichtet werden. Der erfindungsgemäße Eisenkern ist demnach klein sowie preiswert und fremdfeldsicher.

Der Stromleiter 13 ist vorzugsweise aus Eisen oder einer Eisenlegierung hergestellt, jedoch kann auch anderes gut leitendes, ferritisches Material - z.B. MUMETALL - zum Einsatz kommen. Auch kann der Stromleiter 13 bimetallisch ausgebildet sein. Im Falle der bimetallischen Ausgestaltung kann MUMETALL mit Kupfer kombiniert werden. Die Verwendung des ferritischen Materials ist jedoch aus Gründen der Abschirmung gegenüber Fremdfeldern nötig, so daß Kupfer allein nicht verwendet werden sollte.

In zwei sich gegenüberliegenden Abschnitten 14, 15 verfügt der erfindungsgemäß ausgestaltete Stromleiter 13 über je eine Einkerbung 16, 17, wobei durch die Einkerbungen 16, 17 gebildete, benachbarte Kanten 18 bzw. 19 voneinander beabstandet sind und demnach einander nicht berühren. Der Magnetfeldsensor 11 ist benachbart -also im Bereich - zu der Einkerbung 17 positioniert. Durch die Einkerbungen 16, 17 wird der den Stromleiter 13 durchfließende Strom U-förmig geführt und als Folge werden die vom zu messenden Strom erzeugten Feldlinien des Magnetfelds durch den Magnetfeldsensor 11 geführt. Der Stromleiter 13 dient demnach als Hin- und Rückleiter.

An dieser Stelle sei darauf hingewiesen, daß die benachbarten Kanten 18 bzw. 19 auch einander überlappen können, ohne jedoch dabei einander zu berühren. Dies ist für die verbesserte Abschirmung des Magnetfeldsensors 11 von Bedeutung.

Auch soll darauf hingewiesen werden, daß der Magnetfeldsensor 11 als magnetoresistiver Sensor ausgebildet sein kann. Magnetoresistive Sensoren verfügen gegenüber Hall-Sensoren über eine höhere Empfindlichkeit sowie Dynamik. Bei Verwendung eines magnetoresistiven Sensors muß lediglich die Einbauweise desselben geändert werden. Dies ist dem hier angesprochenen Fachmann jedoch geläufig.

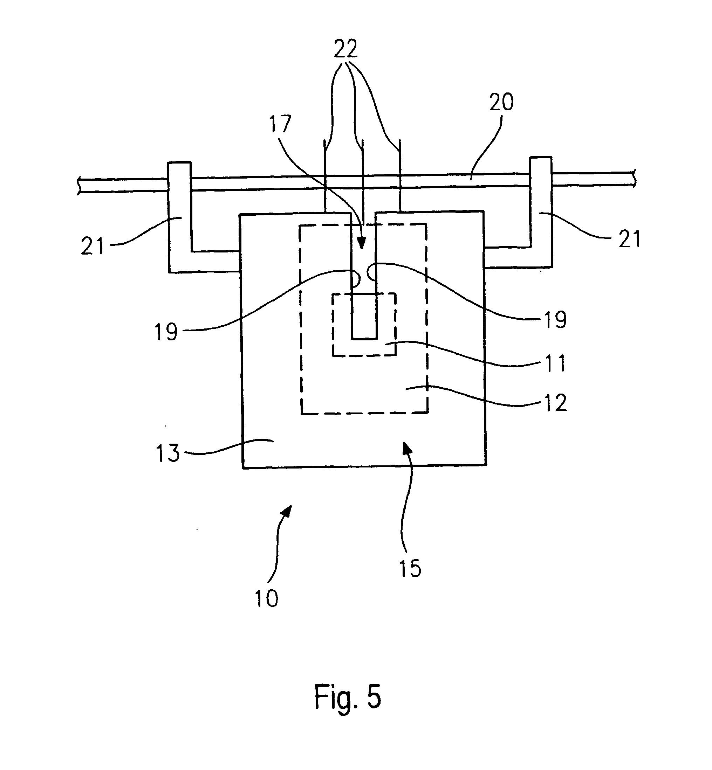

Fig. 5 zeigt den erfindungsgemäßen Stromsensor 10 in seiner bevorzugten Verwendungsform zur Messung des von einer Leiterplatte 20 geführten Stroms. Über Anschlüsse 21 steht der Stromleiter 13 mit nicht dargestellten, den Leiterplattenstrom führenden Leitungen in Kontakt. Über Anschlüsse 22 sind die Meßwerte des Stromsensors 10 zur Weiterverarbeitung abgreifbar.

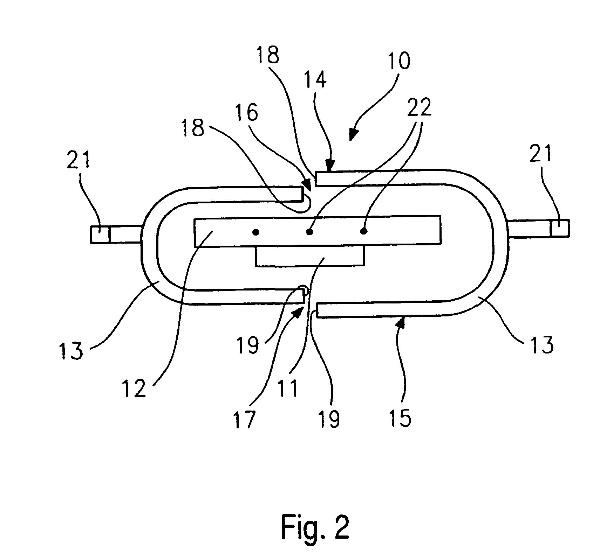

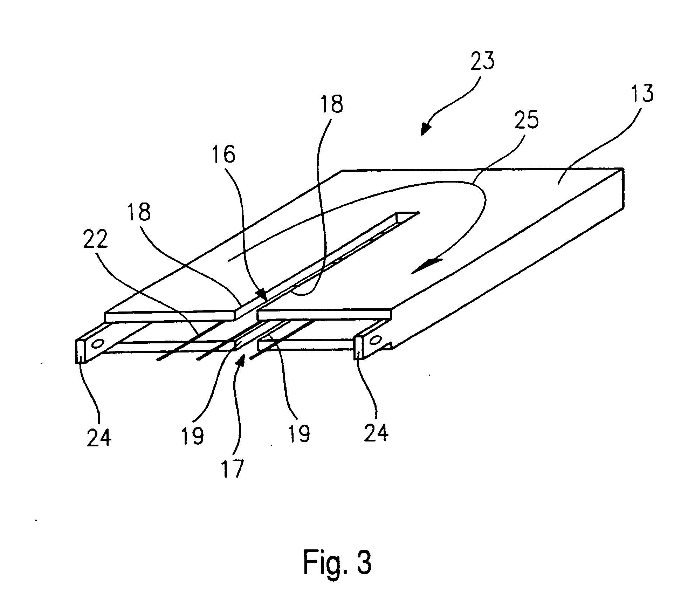

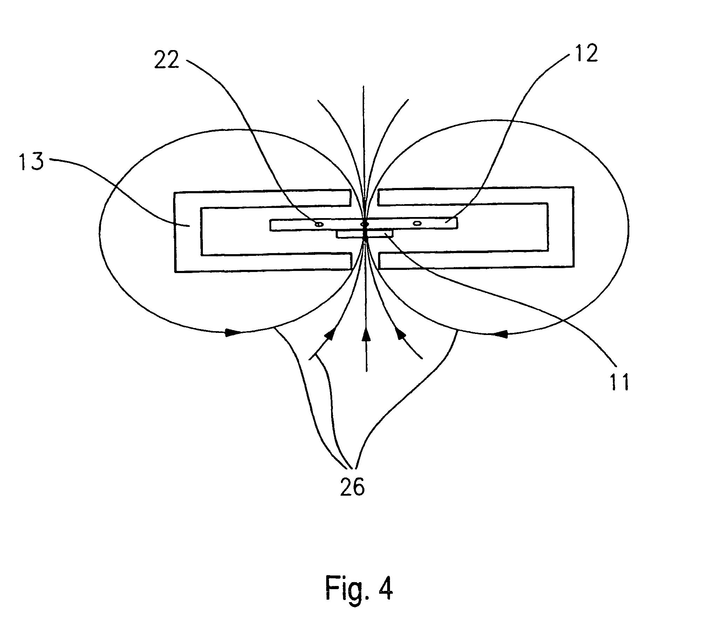

Fig. 3 zeigt einen Stromsensor 23, der im wesentlichen dem Stromsensor 10 der Fig. 1 und 2 entspricht, jedoch geradlinig verlaufende Anschlüsse 24 aufweist. Hinsichtlich aller anderen Details entspricht der Stromsensor 23 jedoch dem Stromsensor 10. Es werden daher für gleiche Baugruppen gleiche Bezugsziffern verwendet. Der Pfeil 25 verdeutlicht, daß der den Stromleiter 13 durchfließende Strom u-förmig geführt wird. Daraus folgt der in Fig. 4 verdeutlichte Verlauf der erzeugten Feldlinien 26, die so durch den Magnetfeldsensor 11 geführt werden.

### Bezugszeichenliste

- 10: Stromsensor
- 11: Magnetfeldsensor
- 12: Trägerplatte
- 13: Stromleiter
- 14: Abschnitt
- 15: Abschnitt
- 16: Einkerbung
- 17: Einkerbung
- 18: Kanten
- 19: Kanten
- 20: Leiterplatte
- 21: Anschluß
- 22: Anschluß
- 23: Stromsensor
- 24: Anschluß
- 25: Pfeil
- 26: Feldlinien

## Patentansprüche

1. Stromsensor zum Messen des von einem Stromleiter (13) geführten Stroms mit einem Magnetfeldsensor (11), mit folgenden Merkmalen:
(a) der Stromleiter (13) weist eine bandförmige Gestalt auf,
(b) der Stromleiter (13) ist um den Magnetfeldsensor (11) herum angeordnet, derart, dass der Stromleiter (13) den Magnetfeldsensor (11) zumindest bereichsweise umschließt,
(c) der Stromleiter (13) weist mindestens eine Einkerbung (16, 17) auf, wobei die durch die oder jede Einkerbung (16, 17) gebildeten, benachbarten Kanten (18, 19) voneinander beabstandet sind,
(d) der Magnetfeldsensor (11) ist benachbart zu der oder jeden Einkerbung (16, 17) des Stromleiters (13) angeordnet,
(e) der Stromleiter (13) ist aus leitendem, ferritischem Material hergestellt,
**dadurch gekennzeichnet, dass**
(f) die benachbarten Kanten (18, 19) einander berührungslos überlappen.

2. Stromsensor nach Anspruch 1,
**dadurch gekennzeichnet, dass**
der Stromleiter (13) in zwei sich vorzugsweise gegenüber liegenden Abschnitten (14, 15) je eine Einkerbung (16, 17) aufweist.

3. Stromsensor nach Anspruch 1 oder 2,
**dadurch gekennzeichnet, dass**
der Stromleiter (13) den Magnetfeldsensor (11) röhrenförmig, insbesondere gehäuseförmig, umschließt.

4. Stromsensor nach Anspruch 1,
**dadurch gekennzeichnet, dass**
der Stromleiter (13) aus Eisen oder einer Eisenlegierung hergestellt ist.

5. Stromsensor nach Anspruch 1,
**dadurch gekennzeichnet, dass**
der Stromleiter (13) bimetallisch ausgebildet ist.

## Claims

1. Current sensor for measuring the current carried by a conductor (13) with a magnetic field sensor (11), with the following features:
(a) the conductor (13) has a strip-form design,
(b) the conductor (13) is disposed around the magnetic field sensor (11) so that the magnetic field sensor (11) is at least partially surrounded by the conductor (13),
(c) the conductor (13) has at least one notch (16, 17) with the adjacent edges (18, 19) formed by the, or each, notch (16, 17) spaced apart from each other,
(d) the magnetic field sensor (11) is arranged adjacently to the, or each, notch (16, 17) of the conductor (13),
(e) the conductor (13) is made from conducting ferritic material,
**characterized in that**
(f) the adjacent edges (18, 19) contactlessly overlap each other.

2. Current sensor according to Claim 1,
**characterized in that**
the conductor (13) has a notch (16, 17) in each of two, preferably opposite, portions (14, 15).

3. Current sensor according to Claim 1 or Claim 2,
**characterized in that**
the conductor (13) surrounds the magnetic field sensor (11) in tubular, and in particular casing-like, fashion.

4. Current sensor according to Claim 1,
**characterized in that**
the conductor (13) is made from iron or iron alloy.

5. Current sensor according to Claim 1,
**characterized in that**
the conductor (13) is of bimetallic configuration.

## Revendications

1. Détecteur de courant pour mesurer le courant amené par un conducteur (13), comportant un détecteur de champ magnétique (11), avec les caractéristiques suivantes :
(a) le conducteur (13) a la forme d'une bande,
(b) le conducteur (13) est disposé autour du détecteur de champ magnétique (11) de telle sorte qu'il entoure au moins par zones ledit détecteur (11),
(c) le conducteur (13) présente au moins une encoche (16, 17), les bords voisins (18, 19) formés par les encoches ou par chaque encoche (16, 17) étant espacés,
(d) le détecteur de champ magnétique (11) est disposé près de l'encoche ou de chaque encoche (16, 17) du conducteur (13),
(e) le conducteur (13) est fabriqué à partir d'un matériau conducteur ferritique,
**caractérisé en ce que**
(f) les bords voisins (18, 19) se chevauchent sans se toucher.

2. Détecteur de courant selon la revendication 1, **caractérisé en ce que** le conducteur (13) présente dans deux sections (14, 15) de préférence opposées une encoche (16, 17).

3. Détecteur de courant selon la revendication 1 ou 2, **caractérisé en ce que** le conducteur (13) entoure suivant une forme tubulaire, en particulier suivant la forme d'un boîtier, le détecteur de champ magnétique (11).

4. Détecteur de courant selon la revendication 1, **caractérisé en ce que** le conducteur (13) est fabriqué en fer ou en alliage de fer.

5. Détecteur de courant selon la revendication 1, **caractérisé en ce que** le conducteur (13) est bimétallique.
